# EUROPEAN PATENT APPLICATION

(11) **EP 4 318 823 A1**
(43) Date of publication of application: **07.02.2024**
(21) Application number: 21938195.1
(22) Date of filing: 25.04.2021
(51) Int. Cl.: H01R 24/38, H05K 3/32

(54) **CONNECTION DEVICE AND RADIO FREQUENCY MODULE**

(71) Applicant: Huawei Technologies Co., Ltd., Longgang Shenzhen, Guangdong 518129 (CN)
(72) Inventor: ZHENG, Fuhui, Shenzhen, Guangdong 518129 (CN); ZHANG, Wenying, Shenzhen, Guangdong 518129 (CN); ZHOU, Xiaolin, Shenzhen, Guangdong 518129 (CN); CHEN, Fang, Shenzhen, Guangdong 518129 (CN); CHONG, Yuliang, Shenzhen, Guangdong 518129 (CN); MA, Yuanming, Shenzhen, Guangdong 518129 (CN)
(74) Representative: Körber, Martin Hans
(86) International application number: PCT/CN2021/089707
(87) International publication number: WO 2022/226704

(57) **Abstract**

This application provides a connection apparatus and a radio frequency module, to meet usage requirements such as low costs, low stacking height, and high reliability. Specifically, the connection apparatus includes a conductor assembly and a fastening structure. The fastening structure is configured to fasten the conductor assembly. The conductor assembly includes an outer conductor, an inner conductor, and an insulating elastomer. The inner conductor covers a surface of the insulating elastomer, and the outer conductor and the inner conductor are electrically insulated.

## Description

### TECHNICAL FIELD

This application relates to the communications field, and in particular, to a connection apparatus and a radio frequency module.

### BACKGROUND

With the development of wireless communication technologies, miniaturization, integration, and modularization of a wireless base station have become a main development direction of the wireless base station. Generally, the wireless base station includes a plurality of devices such as a transceiver, a filter, and an antenna, and different devices are connected through a connection apparatus, for example, a radio frequency connector.

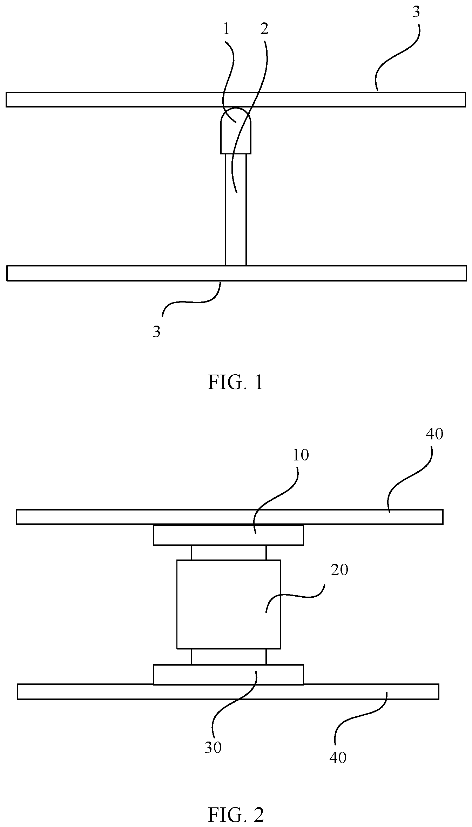

Currently, based on different device-to-device connection scenarios, the connection apparatus may implement a device-to-device connection such as a connection between printed circuit boards (a board-to-board connection), or a connection between a printed circuit board and a filter. The board-to-board connection is used as an example. FIG. 1 and FIG. 2 respectively show schematic structural diagrams of two different connection apparatuses in a conventional technology for implementing the board-to-board connection. As shown in FIG. 1, the connection apparatus may include inner conductor components: an elastic contact pin 1 and an inner core 2. One end of the elastic contact pin 1 is connected to a circuit board 3 in a manner of abutting, the other end of the elastic contact pin 1 is connected to one end of the inner core 2, and another end of the inner core 2 is connected to another circuit board 3. Therefore, the elastic contact pin 1 and the inner core 2 may form a path between the two circuit boards 3, to implement signal transmission between the two circuit boards 3. As shown in FIG. 2, the connection apparatus may include an insertion end 10, a connecting bar 20, and an import end 30. The insertion end 10 is welded on a circuit board 40, and the import end 30 is welded on another circuit board 40.

However, structures of the foregoing two connection apparatuses are complex and are at high costs. In addition, to ensure that a connection between a device and the connection apparatus is not interrupted in a scenario in which external vibration exists, that is, to ensure high reliability of signal transmission between devices, the foregoing two connection apparatuses each have a specific stacking height (stacking height, stacking height) requirement, and therefore cannot meet a usage requirement in a low-stacking-height scenario.

### SUMMARY

This application provides a connection apparatus and a radio frequency module, to meet usage requirements such as low costs, low stacking height, and high reliability.

According to a first aspect, a connection apparatus is provided. The connection apparatus includes a conductor assembly and a fastening structure. The fastening structure is configured to fasten the conductor assembly. The conductor assembly includes an outer conductor, an inner conductor, and an insulating elastomer. The inner conductor covers a surface of the insulating elastomer, and the outer conductor and the inner conductor are electrically insulated.

Based on the connection apparatus provided in this application, the inner conductor and the insulating elastomer are combined to form a connection end. Elastic resilience of the insulating elastomer ensures high reliability of the connection end when the connection end is configured for connection. In addition, because the insulating elastomer can still maintain good elastic resilience when in a small size, the insulating elastomer can meet a requirement of the small size, that is, a requirement of a low stacking height. Additionally, the connection apparatus has a simple structure and low preparation costs, in other words, can meet a low-cost requirement.

With reference to the first aspect, in some implementations of the first aspect, the insulating elastomer in a ring-shaped structure, and the inner conductor covers an inner surface of the insulating elastomer.

This application provides a structure in which the inner surface of the insulating elastomer is covered with the inner conductor. Because the structure is simple, a simple preparation manner may be used when the structure is prepared, for example, a preparation manner such as performing extrusion molding and cutting on materials of the inner conductor and the insulating elastomer is used. This is easy to prepare and has low preparation costs.

With reference to the first aspect, in some implementations of the first aspect, the inner conductor further covers an end surface of the insulating elastomer.

The connection end is formed by covering the end surface of the insulating elastomer with the inner conductor, so that when the connection end is configured to connect a device, full contact with the device can be ensured, and reliability of signal transmission between devices can be further improved.

With reference to the first aspect, in some implementations of the first aspect, the outer conductor covers an outer surface of the insulating elastomer.

This application provides a structure in which the outer surface of the insulating elastomer is covered with the outer conductor. Because the structure is simple, a simple preparation manner may be used when the structure is prepared, for example, a preparation manner such as performing extrusion molding and cutting on materials of the outer conductor and the insulating elastomer is used. This is easy to prepare and has low preparation costs.

With reference to the first aspect, in some implementations of the first aspect, the outer conductor further covers the end surface of the insulating elastomer.

The connection end is formed by covering the end surface of the insulating elastomer with the outer conductor, so that when the connection end is configured to connect a device, full contact with the device can be ensured, and reliability of signal transmission between devices can be further improved.

With reference to the first aspect, in some implementations of the first aspect, the inner conductor further covers an outer surface of the insulating elastomer. The outer conductor is provided with a through hole, where the inner conductor, the insulating elastomer, and a fastening post are disposed in the through hole.

This application provides a structure in which the outer surface of the insulating elastomer is covered with the inner conductor. Because the structure is simple, a simple preparation manner may be used when the structure is prepared, for example, a preparation manner such as performing extrusion molding and cutting on materials of the inner conductor and the insulating elastomer is used. This is easy to prepare and has low preparation costs. Additionally, the inner conductor, the insulating elastomer, and the fastening post are disposed in the through hole of the outer conductor, so that when the connection apparatus is connected to a device, the outer conductor can function as shielding and isolation and impedance matching, to improve reliability of signal transmission between devices. In addition, the outer conductor may be used as a structural component, and is configured to fasten a device when connected to the device, to ensure stability of a connection between the devices, and functions as shielding and isolation and impedance matching.

With reference to the first aspect, in some implementations of the first aspect, the fastening structure is a fastening post, and there is an insertion structure between the fastening post and the conductor assembly.

In this application, the insertion structure is disposed between the fastening post and the conductor assembly and is simple. This facilitates fastening the fastening post and positioning the conductor assembly. In addition, when the fastening post and the conductor assembly are in an interference fit (interference fit), stability of a connection between the fastening post and the conductor assembly is further improved.

With reference to the first aspect, in some implementations of the first aspect, the fastening structure is provided with a through hole, and the conductor assembly is disposed in the through hole.

The fastening structure provided with the through hole may be used as a structural component. When the connection apparatus is connected to a device, the fastening structure may be configured to fasten the device while fastening and positioning the conductor assembly. This ensures stability of a connection between devices and makes the connection apparatus simple in structure, easy prepare, and low in costs.

With reference to the first aspect, in some implementation of the first aspect, one end of the insulating elastomer is in an arc shape; the inner conductor covers an outer surface of the arc-shaped end of the insulating elastomer; and the outer conductor is provided with a through hole, where the inner conductor, the insulating elastomer and the fastening post are disposed in the through hole.

The one end of the insulating elastomer is set to be arc-shaped, so that when the arc-shaped end is squeezed, a resilient force of the connection end can be reduced, to avoid deformation of the connected structure caused by the resilient force.

With reference to the first aspect, in some implementations of the first aspect, another end of the insulating elastomer is provided with a hole; the fastening structure is a columnar step-shaped structure; and an insertion structure is formed between the fastening structure and the insulating elastomer through the hole and the columnar step-shaped structure.

The fastening structure is set to be the columnar step-shaped structure. When a stacking height of the connection apparatus needs to be adjusted, only a height of the fastening structure needs to be adjusted, while heights of structures such as the insulating elastomer and the inner conductor does not need to be adjusted. Therefore, setting the fastening structure to be the columnar step-shaped structure enables the stacking height of the connection apparatus to be easily adjusted.

With reference to the first aspect, in some implementations of the first aspect, the insulating elastomer includes: silicone rubber, nitrile butadiene rubber, or fluorosilicone rubber.

With reference to the first aspect, in some implementations of the first aspect, the inner conductor or the outer conductor includes: silver paste, tin, silver, copper, nickel, or alloy.

According to a second aspect, a radio frequency module is provided, including at least one device and the connection apparatus according to at least one of the foregoing implementations of the first aspect. The device is disposed with an interface. The interface includes an inner conductor connection interface, an outer conductor connection interface, and an insulation area. The insulation area insulates the inner conductor connection interface and the outer conductor connection interface. One end of an inner conductor of the connection apparatus is connected to the inner conductor connection interface, and one end of an outer conductor of the connection apparatus is connected to the outer conductor connection interface.

With reference to the second aspect, in some implementations of the second aspect, the device includes a circuit board or a filter.

### BRIEF DESCRIPTION OF DRAWINGS

FIG. 1 is a schematic structural diagram of a connection apparatus for implementing a board-to-board connection in a conventional technology;
FIG. 2 is a schematic structural diagram of another connection apparatus for implementing a board-to-board connection in a conventional technology;
FIG. 3 is a top view of a device interface according to an embodiment of this application;
FIG. 4 is a schematic structural diagram of a specific example of a radio frequency module according to an embodiment of this application;
FIG. 5 is a schematic structural diagram of a specific example of a connection apparatus according to an embodiment of this application;
FIG. 6 is a schematic structural diagram of a specific example of a radio frequency module according to an embodiment of this application;
FIG. 7 is a schematic structural diagram of a specific example of a connection apparatus according to an embodiment of this application;
FIG. 8 is a schematic structural diagram of a specific example of a radio frequency module according to an embodiment of this application;
FIG. 9 is a schematic structural diagram of a specific example of a connection apparatus according to an embodiment of this application;
FIG. 10 is a schematic structural diagram of a specific example of a radio frequency module according to an embodiment of this application; and
FIG. 11 is a schematic structural diagram of a specific example of a connection apparatus according to an embodiment of this application.

### DESCRIPTION OF EMBODIMENTS

The following describes technical solutions of this application with reference to accompanying drawings.

To help a person skilled in the art understand the technical solutions of this application, the following first describes a usage scenario of a connection apparatus.

The connection apparatus sometimes may also be referred to as a board-to-board connection apparatus or a board-to-board connector, and is mainly configured for interconnection between devices that need to be connected, such as a circuit board, a filter, and an antenna. A radio frequency connector is a common connection apparatus, and is configured to implement a connection between radio frequency devices. For example, when a connection between printed circuit boards (printed circuit boards, PCBs), that is, a board-to-board connection is implemented, two connected circuit boards are generally disposed in parallel and are spaced. In other words, the connection apparatus may be connected between two circuit boards disposed in parallel, to implement an electrical connection between the circuit boards. Generally, the circuit boards each have electrical connection points such as a first signal end and a second signal end, that is, interfaces. Therefore, the connection apparatus can implement a connection between first signal ends of the two circuit boards and a connection between second signal ends of the two circuit boards. In other words, an effective path between the two circuit boards is formed. Similarly, the connection apparatus may be configured to implement a connection between devices such as a circuit board and a filter, or may be configured to implement a connection between devices such as an antenna and a filter, or may be configured to implement a connection and between devices such as filters.

It should be understood that in this application, the electrical connection includes all connection manners of connecting different conductive structures.

To connect devices such as a circuit board and a filter that need to be connected, this application provides a connection apparatus of low costs, low stacking height, and high reliability.

The connection apparatus provided in this application includes a conductor assembly and a fastening structure. The fastening structure is configured to fasten the conductor assembly.

In a possible implementation, the connection apparatus may be disposed between devices to connect the two devices, to implement an electrical connection and signal transmission between the devices.

The devices may include radio frequency devices, for example, radio frequency devices such as a PCB board and a filter that need to be connected. This is not limited in this application.

Optionally, one radio frequency module may include at least one radio frequency device, and a connection apparatus that is connected to the device.

The fastening structure may be fastened to the device and connected to a part or all of a structure in the conductor assembly, to fasten and position the conductor assembly. Optionally, the fastening structure may be further configured to assist the conductor assembly, to implement an electrical connection and signal transmission. A manner of fastening and connecting the fastening structure and the device may include welding, press riveting, injection, or the like. This is not limited in this application. In addition, the fastening structure and the part or all of the structure in the conductor assembly may be a detachable structure of an interference fit (interference fit), to prevent a corresponding structure in the conductor assembly from falling off.

It should be understood that the fastening structure may be made of an insulating material or a conductive medium material. When the fastening structure is made of the conductive medium material, the fastening structure may be configured to assist the conductor assembly to implement the electrical connection and signal transmission between the devices.

It should be further understood that the fastening structure may be in a plurality of shapes, for example, a columnar shape, a cylindrical shape, or a ring shape. This is not limited in this application. For example, when the fastening structure is a columnar structure, the fastening structure may be connected to part of a through hole structure in the conductor assembly to fasten the part of the through hole structure. When the fastening structure is a cylindrical structure or a ring-shaped structure, in other words, the fastening structure may be provided with a through hole, the part or all of the structure in the conductor assembly may be disposed in the through hole of the fastening structure.

The conductor assembly includes an outer conductor, an inner conductor, and an insulating elastomer. Specifically, the inner conductor is made of a conductive medium material, and covers a surface of the insulating elastomer, to implement signal transmission. The outer conductor is also made of a conductive medium material, and is disposed around an outer side of the inner conductor, that is, disposed on the outer side of the inner conductor and electrically insulated from the inner conductor. In other words, there is a gap between the outer conductor and the inner conductor, and the outer conductor functions as shielding and isolation and impedance matching. The insulating elastomer is made of an electrically insulated non-metallic elastic material with good elastic performance. For example, an insulating elastomer with a compression amount of 20% and a compression set of less than 15% due to long-term aging may be considered, to avoid non-rebound after long-term usage and ensure good elastic resilience.

It should be understood that in this embodiment of this application, different impedance matching between the inner conductor and the outer conductor may be implemented by adjusting structural parameters of the inner conductor and/or the outer conductor, or by adjusting a distance between the inner conductor and the outer conductor.

It should be further understood that the conductive medium material for preparing the inner conductor or the outer conductor may be any one or more of the following: silver paste, silver, tin, copper, nickel, and alloy. This is not limited in this application. It should be further understood that the non-metal elastic material for preparing the insulating elastomer may be any one or more of the following: silicone rubber, nitrile butadiene rubber, or fluorosilicone rubber. This is not limited in this application.

In this embodiment of this application, the insulating elastomer may be in a solid structure, where a surface of the solid structure may be a plane or in an arc shape, for example, a sphere, an ellipsoid, a cylinder, a cube, or a three-dimensional structure of an irregular shape. Alternatively, the insulating elastomer may be a three-dimensional structure provided with a through hole, a blind via, or the like. For example, the insulating elastomer is in a ring-shaped structure. It should be understood that the ring-shaped structure may be in a circular shape, a square shape, a triangular shape, an irregular shape, and the like. This is not limited in this application. For another example, the insulating elastomer may be in an arched structure, an inverted U-shaped structure, a cap, and the like. This is not limited in this application.

In this embodiment of this application, that the inner conductor covers the surface of the insulating elastomer includes: The inner conductor covers part or all of the surface of the insulating elastomer. This is not limited in this application. As the material of the inner conductor, the conductive medium material may be a material that has good electrical performance and is easy to be combined with the insulating elastomer, for example, various metal coatings such as silver paste.

For a thickness of the inner conductor, an influence of a skin effect of a high-frequency signal is considered, and the thickness of the inner conductor may be greater than a skin depth. For example, when the conductive medium material of the inner conductor is silver paste, and a frequency of a signal transmitted in the inner conductor is 2.6 GHz, a thickness of the silver paste may be about 20 µm to 25 µm.

Therefore, a connection end is formed by combining the inner conductor and the insulating elastomer. Based on elastic performance of the insulating elastomer, the connection end has good elastic resilience during compression deformation. This ensures high reliability of the connection end when the connection end is configured for connection. For example, when the connection apparatus is configured to connect devices, problems such as assembly tolerance between devices and unevenness and roughness of device surfaces do not affect normal connections and signal transmission between the inner conductor and the devices. In other words, high reliability of the connections is ensured. In addition, because the insulating elastomer can still maintain good elastic resilience when in a small size, a requirement of the small size can be met, and a low-stacking-height connection can be implemented. In addition, the connection apparatus has a simple structure, is easy to be prepared, and has low preparation costs. This can meet a low-cost requirement.

Optionally, the connection apparatus further includes a structural component. The structural component may be fastened to a device through a fastener. In other words, the structural component is configured to fasten the foregoing device, to ensure stability of a connection between devices. The structural component may be another structure different from the conductor assembly and the fastening structure. Alternatively, the structural component may be a part of the structure in the conductor assembly, for example, an outer conductor. In other words, the outer conductor implements fastening, shielding and isolation, and impedance matching. Alternatively, the structural component is a fastening structure. In other words, the fastening structure functions as fastening of the conductor assembly and the device.

It should be understood that a manner of covering the surface of the insulating elastomer by the inner conductor and/or the outer conductor may be at least one of the following: extrusion molding, electroplating, coating, sputtering, vapor deposition, and pad printing. This is not limited in this application.

The following describes the connection apparatus provided in this application by using an example in which the connection apparatus is configured to connect two PCB boards disposed in parallel.

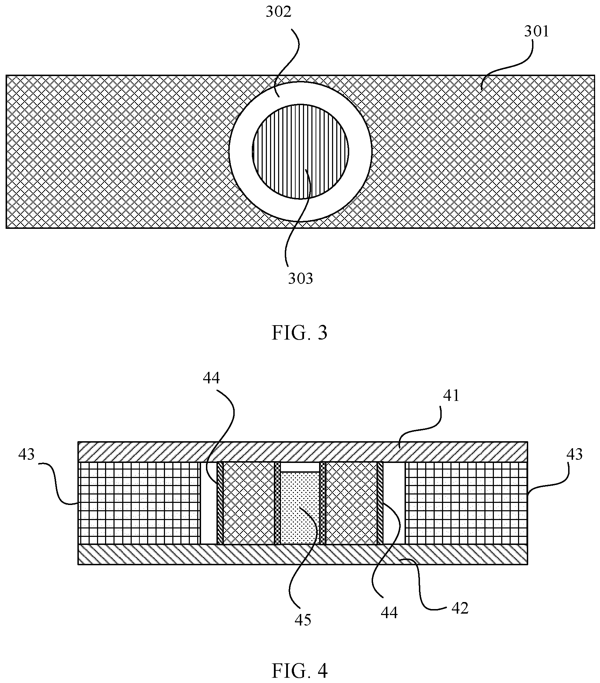

To implement an electrical connection between the PCB board and the connection apparatus, an interface is disposed on a surface of the PCB board. For example, FIG. 3 is a top view of an interface on a PCB board. The interface is used for the electrical connection between the PCB board and the connection apparatus. As shown in FIG. 3, an outer conductor connection interface 301, an insulation area 302, and an inner conductor connection interface 303 are included.

It should be understood that to ensure reliability of a connection between the interface and the connection apparatus, in various scenarios, for example, in a scenario of vibration, size settings of an outer conductor connection interface and an inner conductor connection interface in the interface need to ensure that an electrical connection to a corresponding structure of the connection apparatus is not interrupted. For example, part that is of an inner conductor included in the connection apparatus and that is in contact with the inner conductor connection interface is in a circular shape. This part is referred to as an inner conductor contact part for short. Part that is of an outer conductor included in the connection apparatus and that is in contact with the outer conductor connection interface is in a ring shape. This part is referred to as an outer conductor contact part for short. In addition, when the inner conductor connection interface and the outer conductor connection interface are in a shape shown in FIG. 3, a diameter of the inner conductor connection interface 303 may be greater than a diameter of the circular-shaped inner conductor contact part, and an inner diameter of the outer conductor connection interface 301 may be less than an inner diameter of the circular ring-shaped outer conductor contact part, to ensure that the connection between the interface and the connection apparatus is not interrupted.

It should be understood that the interface shown in FIG. 3 may alternatively be provided on a device connected to another connection apparatus such as a filter. This is not limited in this application.

FIG. 4 shows a schematic structural diagram of a specific example of a radio frequency module according to this application.

FIG. 4 shows a sectional view of a radio frequency module. The radio frequency module includes a connection apparatus and upper and lower devices 41 and 42. The connection apparatus includes a conductor assembly 44 and a fastening post 45. Optionally, the connection apparatus may further include a structural component 43.

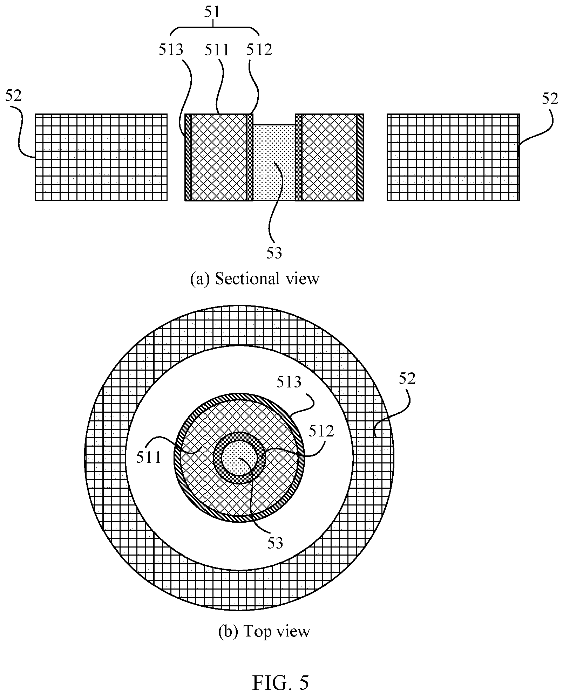

The connection apparatus corresponding to FIG. 4 is described below with reference to FIG. 5. In other words, FIG. 5 shows a schematic structural diagram of a specific example of a connection apparatus according to this application.

(a) and (b) in FIG. 5 respectively show a sectional view and a top view of the connection apparatus. The connection apparatus includes a conductor assembly 51 and a fastening post 53. Optionally, the connection apparatus may further include a structural component 52.

The structural component 52 may be in a circular ring-shaped columnar structure, and may be connected to the upper and lower devices 41 and 42 in FIG. 4 through a fastener such as a screw, a bolt, a stud, or a rivet, that is, a fastener that enables the structural component to be connected and fastened to the devices. This is not limited in this application.

The fastening post 53 may be in a cylindrical structure, and may be fastened to the device 42 in FIG. 4, to function as fastening and positioning of the conductor assembly 51. Optionally, a manner of fastening and connecting the fastening post and the device includes welding, press riveting, injection molding, and the like. This is not limited in this application.

Optionally, the fastening post 53 and the conductor assembly 51 are disposed coaxially, and are in an insertion structure. The fastening post and the conductor assembly may be in an interference fit. In other words, a diameter of the fastening post 53 is greater than an inner diameter of the conductor assembly 51, to prevent the conductor assembly 51 from falling off.

The following describes a structure of the conductor assembly 51.

In a specific example, the conductor assembly 51 is in a circular ring-shaped columnar structure, and includes an insulating elastomer 511, an inner conductor 512, and an outer conductor 513. The insulating elastomer 511 is in a circular ring-shaped columnar structure, and the inner conductor 512 and the outer conductor 513 respectively cover inner and outer surfaces of the insulating elastomer 511, or in other words, respectively cover inner and outer side surfaces of the insulating elastomer 511.

When the conductor assembly is configured to connect a device, for example, when the conductor assembly 51 is connected to the interface shown in FIG. 3, one end of the inner conductor 512 of the conductor assembly 51 is in contact with the inner conductor connection interface 303 of the interface to implement an electrical connection, one end of the outer conductor 513 is in contact with the outer conductor connection interface 301 of the interface to implement an electrical connection, and electrical insulation between the inner conductor and the outer conductor is implemented through the insulating elastomer. In this case, the conductor assembly 51 may implement an electrical connection and signal transmission between devices, that is, implement an electrical connection and signal transmission between PCB boards. Optionally, a contact manner between one end of the inner conductor 512 and the inner conductor connection interface 303 may be pressing and abutting, and a contact manner between one end of the outer conductor 513 and the outer conductor connection interface 301 may be pressing and abutting.

To enable the conductor assembly to be in full contact with the device and improve reliability of signal transmission between devices implemented by the conductor assembly, an outer diameter of one end of the inner conductor 512 of the conductor assembly 51 may be set to be less than a diameter of the inner conductor connection interface 303, and an inner diameter of one end of the outer conductor 513 is greater than an inner diameter of the outer conductor connection interface 301.

For a preparation manner of the conductor assembly 51, a possible implementation is as follows. First, extrusion molding is performed on a non-metal elastic material and a conductive medium layer. Subsequently, cutting is performed to obtain a circular ring-shaped columnar structure with a specific length, for example, a circular ring-shaped columnar structure with a length of about 2 mm. In this case, an inner surface and an outer surface of the circular ring-shaped columnar structure are respectively covered with the conductive medium layers. The conductive medium layer on the inner surface is the inner conductor, and the conductive medium layer on the outer surface is the outer conductor.

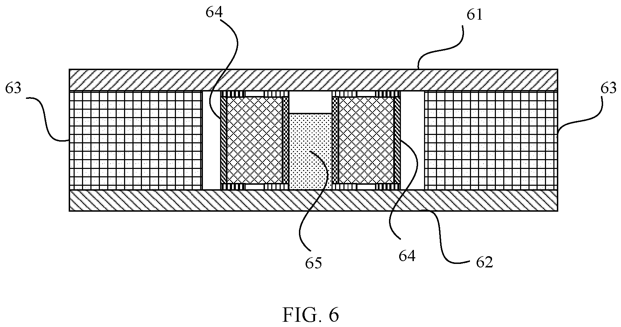

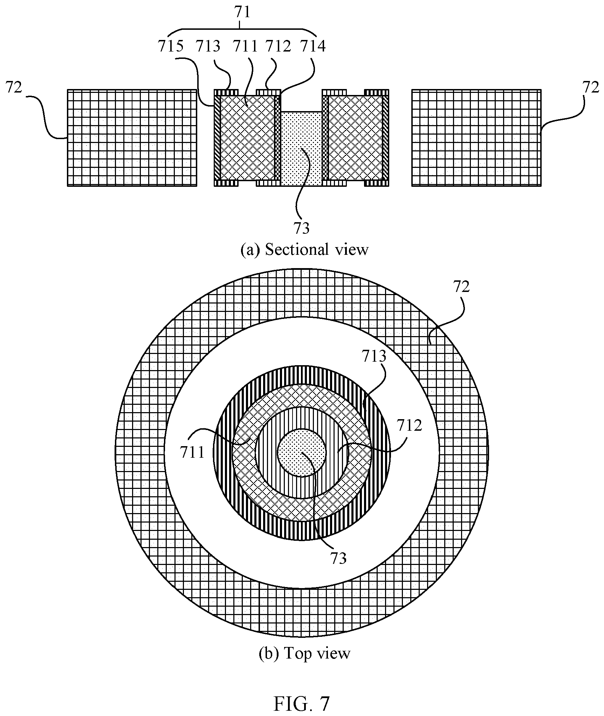

Optionally, as shown in FIG. 6 and FIG. 7, an end surface of the foregoing conductor assembly 51 may alternatively be covered with a conductive medium layer, so that the inner conductor and outer conductor of the conductor assembly are in full contact with the inner and outer conductor connection interfaces of the upper and lower devices, to improve reliability of signal transmission between the upper and lower devices implemented by the conductor assembly.

FIG. 6 shows a schematic structural diagram of another specific example of a radio frequency module according to this application, and FIG. 7 shows a schematic structural diagram of another specific example of a connection apparatus according to this application.

It should be noted that part of a structure of the radio frequency module shown in FIG. 6 is the same as part of a structure of the radio frequency module shown in FIG. 4, and part of a structure of the connection apparatus shown in FIG. 7 is the same as part of a structure of the connection apparatus shown in FIG. 5. Therefore, for the structures in FIG. 6 and FIG. 7, refer to the descriptions in FIG. 4 and FIG. 5, and details are not described herein again.

FIG. 6 shows a sectional view of the radio frequency module. The radio frequency module includes a connection apparatus and upper and lower devices 61 and 62. The connection apparatus includes a conductor assembly 64 and a fastening post 65. Optionally, the connection apparatus may further include a structural component 63.

The connection apparatus corresponding to FIG. 6 is described below with reference to FIG. 7. In other words, FIG. 7 shows a schematic structural diagram of a specific example of a connection apparatus according to this application.

(a) and (b) in FIG. 7 respectively show a sectional view and a top view of the connection apparatus. The connection apparatus includes a conductor assembly 71 and a fastening post 73. Optionally, the connection apparatus may further include a structural component 72.

For descriptions of the structural component 72 and the fastening post 73 in FIG. 7, refer to a specific description of a corresponding structure in FIG. 5. In other words, 52 and 53 are replaced with 72 and 73.

Different from the conductor assembly 51 in FIG. 5, an end of the conductor assembly 71 in FIG. 7 is covered with a conductive medium. In a specific example, the conductor assembly 71 is in a circular ring-shaped columnar structure, and includes an insulating elastomer 711, inner conductors 712 and 714, and outer conductors 713 and 715.

The insulating elastomer 711 is in a circular ring-shaped columnar structure, and the inner conductor and the outer conductor cover a surface of the insulating elastomer. Additionally, the inner conductor further includes the inner conductor 714 on an inner surface and the inner conductor 712 on an end face, and the inner conductor 714 and the inner conductor 712 are electrically connected to each other. The outer conductor further includes the outer conductor 715 on an outer surface and the outer conductor 713 on the end face, and the outer conductor 715 and the outer conductor 713 are also electrically connected to each other. In addition, there is a gap between the inner conductor 712 on the end face and the outer conductor 713 on the end face. In other words, the inner conductor and the outer conductor are electrically insulated.

When the conductor assembly is configured to connect a device, for example, when the conductor assembly 71 is connected to the interface shown in FIG. 3, the inner conductor 712 on the end face of the conductor assembly 71 is in contact with the inner conductor connection interface 303 to implement an electrical connection, and the outer conductor 713 on the end face is in contact with the outer conductor connection interface 301 to implement an electrical connection. In this case, the conductor assembly 71 may implement an electrical connection and signal transmission between devices, that is, implement an electrical connection and signal transmission between PCB boards. Optionally, a contact manner between the inner conductor 712 on the end face and the inner conductor connection interface 303 may be pressing and abutting, and a contact manner between the outer conductor 713 on the end face and the outer conductor connection interface 301 may be pressing and abutting.

To enable the conductor assembly to be in full contact with the device and improve reliability of signal transmission between devices implemented by conductor assembly, an outer diameter of the inner conductor 712 on the end face of the conductor assembly 71 may be set to be less than a diameter of the inner conductor connection interface 303, and an inner diameter of the outer conductor 713 on the end face of the conductor assembly 71 may be set to be greater than an inner diameter of the outer conductor connection interface 301.

For a preparation manner of the conductor assembly 71, a possible implementation is as follows. First, extrusion molding is performed on a non-metal elastic material and a conductive medium layer. Subsequently, cutting is performed to obtain a circular ring-shaped columnar structure with a specific length, for example, a circular ring-shaped columnar structure with a length of about 2 mm. In this case, an inner surface and an outer surface of the circular ring-shaped columnar structure are respectively covered with the conductive medium layer. The conductive medium layer on the inner surface is an inner conductor, and the conductive medium layer on the outer surface is the outer conductor. Finally, silver paste is coated or printed on the two ends of the structure and then baking is performed, to obtain the inner conductor on the end face and the outer conductor on the end face.

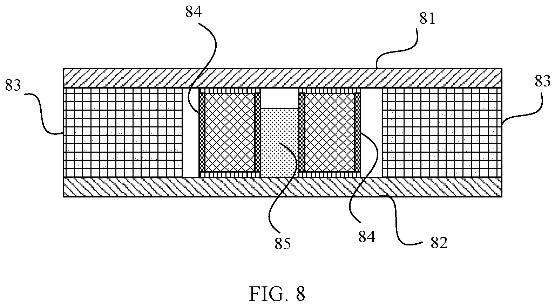

FIG. 8 shows a schematic structural diagram of another specific example of a radio frequency module according to this application.

FIG. 8 shows a sectional view of the radio frequency module. The radio frequency module includes a connection apparatus and upper and lower devices 81 and 82. The connection apparatus includes conductor assemblies 83 and 84, and a fastening post 85.

In a specific example, the conductor assembly specifically includes an outer conductor 83 and an inner conductive component 84 formed by an inner conductor and an insulating elastomer. In this case, the outer conductor 83 may also be referred to as a structural component. In other words, the outer conductor 83 may be configured to fasten the upper and lower devices 81 and 82 in addition to functioning as shielding and isolation and impedance matching. The outer conductor 83 shown in FIG. 8 is in a circular ring-shaped columnar structure. As the structural component, there is a specific distance between the outer conductor 83 and the inner conductive component 84. In other words, the outer conductor is not in contact with the inner conductive component, to ensure electrical insulation between the inner conductor and the outer conductor. In addition, the outer conductor 83 is connected to the upper and lower devices 81 and 82 through a fastener such as a screw, a bolt, a stud, or a rivet, that is, a fastener that enables the outer conductor to be connected and fastened to the devices. This is not limited in this application.

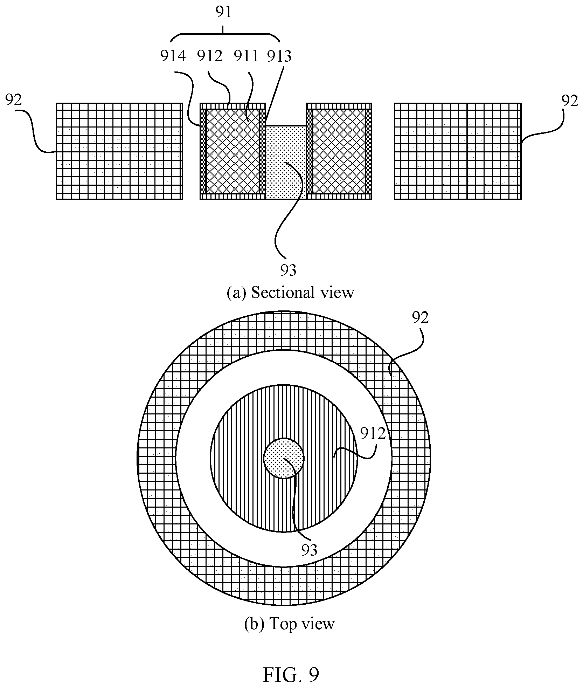

The connection apparatus corresponding to FIG. 8 is described below with reference to FIG. 9. In other words, FIG. 9 shows a schematic structural diagram of a specific example of a connection apparatus according to this application.

(a) and (b) in FIG. 9 respectively show a sectional view and a top view of the connection apparatus. The connection apparatus includes a conductor assembly 91, a conductor assembly 92, and a fastening post 93. The conductor assemblies include an outer conductor 92 and an inner conductive component 91 formed by an inner conductor and an insulating elastomer.

It should be understood that the conductor assembly 91 and the conductor assembly 92 are respectively the same as the conductor assembly 84 and the conductor assembly 83 in FIG. 8. For descriptions of the conductor assembly 91 and the conductor assembly 92, refer to related descriptions in FIG. 8.

Optionally, the fastening post 93 is in a cylindrical structure, and may be fastened to the device 82 in FIG. 8, to function as fastening and positioning of the inner conductive component 91. Optionally, a manner of fastening and connecting the fastening post and the device includes welding, press riveting, injection molding, and the like. This is not limited in this application.

Optionally, the fastening post 93 and the inner conductive component 91 are disposed coaxially, and are in an insertion structure. To prevent the inner conductive component 91 from falling off, the fastening post and the inner conductive component are in an interference fit. In other words, a diameter of the fastening post 93 is greater than an inner diameter of the inner conductive component 91.

The following describes a structure of the inner conductive component 91.

In a specific example, the inner conductive component 91 is in a circular ring-shaped columnar structure, and includes an insulating elastomer 911 and inner conductors 912, 913, and 914. The insulating elastomer 911 is in a circular ring-shaped columnar structure, and the inner conductors 912, 913, and 914 respectively cover an end surface, an inner surface, and an outer surface of the insulating elastomer. In other words, the inner conductor completely covers the insulating elastomer.

When the conductor assembly is configured to connect a device, for example, when the outer conductor 92 and the inner conductive component 91 are connected to the interface shown in FIG. 3, the inner conductor 912 included in the inner conductive component 91 is in contact with the inner conductor connection interface 303 to implement an electrical connection, and one end of the outer conductor 92 is in contact with the outer conductor connection interface 301 to implement an electrical connection. In this case, the conductor assembly may implement an electrical connection and signal transmission between devices, that is, implement an electrical connection and signal transmission between PCB boards. Optionally, a contact manner between the inner conductor 912 and the inner conductor connection interface 303 may be pressing and abutting, and a contact manner between the outer conductor 92 and the outer conductor connection interface 301 may be pressing and abutting through a fastener.

To enable the conductor assembly to be in full contact with the device and improve reliability of signal transmission between devices implemented by the conductor assembly, an outer diameter of one end of the inner conductor 912 may be set to be less than a diameter of the inner conductor connection interface 303, and an inner diameter of one end of the outer conductor 92 is greater than an inner diameter of the outer conductor connection interface 301.

For a preparation manner of the inner conductive component 91, a possible implementation is as follows. First, extrusion molding is performed on a non-metal elastic material and a conductive medium layer. Subsequently, cutting is performed to obtain a circular ring-shaped columnar structure with a specific length, for example, a circular ring-shaped columnar structure with a length of about 2 mm. In this case, an inner surface and an outer surface of the circular ring-shaped columnar structure are respectively covered with the conductive medium layers. The conductive medium layers each are an inner conductor. Finally, silver paste is coated or printed on the two ends of the structure and then baking is performed, to obtain an inner conductor on the end surface.

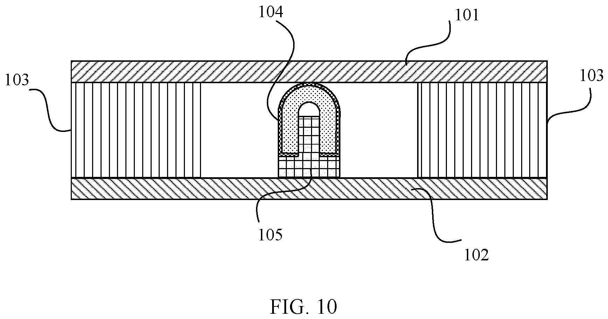

FIG. 10 shows a schematic structural diagram of another specific example of a radio frequency module according to this application.

FIG. 10 shows a sectional view of the radio frequency module. The radio frequency module includes a connection apparatus and upper and lower devices 101 and 102. The connection apparatus includes conductor assemblies 103 and 104, and a fastening post 105.

Optionally, the conductor assembly specifically includes an outer conductor 103 and an inner conductive component 104 formed by an inner conductor and an insulating elastomer. In this case, the outer conductor 103 may also be referred to as a structural component. In other words, the outer conductor 103 may be configured to fasten the upper and lower devices 101 and 102 in addition to functioning as shielding and isolation and impedance matching. The outer conductor 103 shown in FIG. 10 is in a circular ring-shaped columnar structure. As the structural component, there is a specific distance between the outer conductor 103 and the inner conductive component 104. In other words, the outer conductor is not in contact with the inner conductive component, to ensure electrical insulation between the inner conductor and the outer conductor. In addition, the outer conductor 103 is connected to the upper and lower devices 101 and 102 through a fastener such as a screw, a bolt, a stud, or a rivet, that is, a fastener that enables the outer conductor to be connected and fastened to the devices. This is not limited in this application.

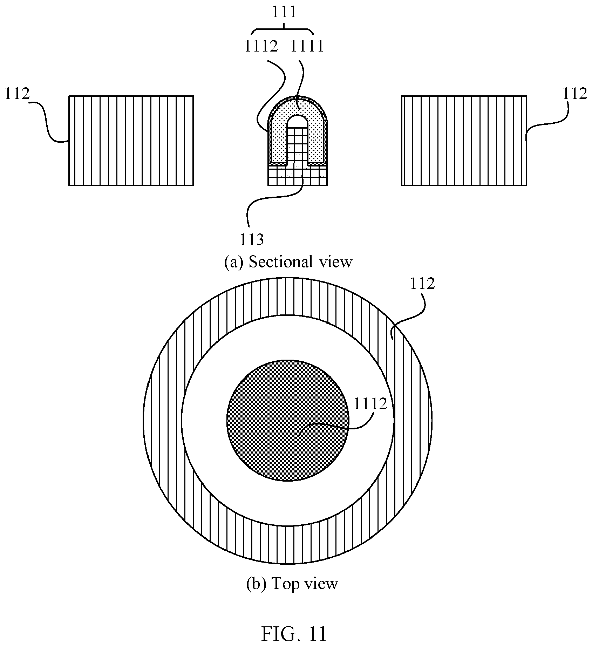

The connection apparatus corresponding to FIG. 10 is described below with reference to FIG. 11. In other words, FIG. 11 shows a schematic structural diagram of a specific example of a connection apparatus according to this application.

(a) and (b) in FIG. 11 respectively show a sectional view and a top view of the connection apparatus. The connection apparatus includes a conductor assembly 111, a conductor assembly 112, and a fastening post 113. The conductor assemblies include an outer conductor 112 and an inner conductive component 111 formed by an inner conductor and an insulating elastomer.

It should be understood that the conductor assembly 111 and the conductor assembly 112 are respectively the same as the conductor assembly 104 and the conductor assembly 103 in FIG. 10. For descriptions of the conductor assembly 111 and the conductor assembly 112, refer to related descriptions in FIG. 10.

In a specific example, the fastening post 113 is in a cylindrical step-shaped structure, may be connected and fastened to the device 102 in FIG. 10, and functions as fastening and positioning of the inner conductive component 111. Optionally, a manner of fastening and connecting the fastening post and the device includes welding, press riveting, injection molding, and the like. This is not limited in this application.

In a specific example, the fastening post 113 and the inner conductive component 111 are coaxially disposed, and are in an insertion structure. To prevent the inner conductive component 111 from falling off, the fastening post and the inner conductive component are in an interference fit. In other words, a diameter of the upper structure of the fastening post 113 is greater than a diameter of a hole of the inner conductive component 111.

The following describes a structure of the inner conductive component 111.

In a specific example, the inner conductive component 111 is in an arch-shaped columnar structure, and includes an insulating elastomer 1111 and an inner conductor 1112. The insulating elastomer 1111 is in an arch-shaped columnar structure with a hole at one end, and the inner conductor 1112 covers an outer surface of the insulating elastomer 1111. Optionally, the inner conductor 1112 may further cover an inner surface of the insulating elastomer 1111.

An arch-shaped structure is used on the top of the inner conductive component, so that a rebound force of the inner conductive component caused by compression can be reduced. Therefore, when the inner conductive component is configured to connect a device, deformation of part that is of the device and that is in contact with the inner conductive component may be reduced.

Optionally, the inner conductor 1112 is connected to the fastening post 113. When configured to connect a device, the fastening post 113 may use a conductive medium, so that the fastening post can implement an electrical connection and signal transmission in addition to functioning as fastening and positioning. In addition, the fastening post is in a step shape, which can facilitate adjustment of a stacking height. For example, when a distance between devices needs to be adjusted, a height of an inner conductive component may not need to be adjusted, and a distance change between devices may be adapted by adjusting a height of a fastening post.

When the conductor assembly is configured to connect a device, for example, when the outer conductor 112 and the inner conductive component 111 are connected to the interface shown in FIG. 3, the inner conductor 1112 included in the inner conductive component 111 is in contact with the inner conductor connection interface 303 to implement an electrical connection, and one end of the outer conductor 112 is in contact with the outer conductor connection interface 301 to implement an electrical connection. In this case, the conductor assembly may implement an electrical connection and signal transmission between devices, that is, implement an electrical connection and signal transmission between PCB boards. Optionally, a contact manner between the inner conductor 1112 and the inner conductor connection interface 303 may be pressing and abutting, and a contact manner between the outer conductor 112 and the outer conductor connection interface 301 may be pressing and abutting through a fastener.

To enable the conductor assembly to be in full contact with the device and improve reliability of signal transmission between devices implemented by the conductor assembly, an outer diameter of one end of the inner conductor 1112 in the top view in (b) in FIG. 11 may be set to be less than a diameter of the inner conductor connection interface 303, and an inner diameter of one end of the outer conductor 112 is greater than an inner diameter of the outer conductor connection interface 301.

For a preparation manner of the inner conductive component 111, a possible implementation is as follows. First, an insulating elastomer in an arch-shaped structure is prepared by using a non-metal elastic material obtained through compression molding. Subsequently, a conductive medium layer is added to an outer surface of the insulating elastomer through coating or electroplating. The conductive medium layer is the inner conductor.

It may be understood that for ease of description, the radio frequency module in the accompanying drawings of this application includes the upper and lower devices connected to the connection apparatus. However, that the radio frequency module necessarily includes two devices connected to the connection apparatus is not limited in this application, and there may be one or more devices connected to the connection apparatus.

In the several embodiments provided in this application, it should be understood that the disclosed systems, apparatuses and methods may be implemented in another manner. For example, the described apparatus embodiments are merely an example. For example, division of the units is merely logical function division and may be other division in actual implementation. For example, a plurality of units or components may be combined or integrated into another system, or some features may be ignored or not performed. In addition, displayed or discussed mutual couplings or direct couplings or communication connections may be implemented through some interfaces. Indirect couplings or communication connections between the apparatuses or units may be implemented in electronic or other forms.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A connection apparatus, wherein the connection apparatus comprises a conductor assembly and a fastening structure, and the fastening structure is configured to fasten the conductor assembly; and
the conductor assembly comprises an outer conductor, an inner conductor, and an insulating elastomer, wherein the inner conductor covers a surface of the insulating elastomer, and the outer conductor and the inner conductor are electrically insulated.

2. The connection apparatus according to claim 1, wherein the insulating elastomer is in a ring-shaped structure; and
the inner conductor covers an inner surface of the insulating elastomer.

3. The connection apparatus according to claim 2, wherein the inner conductor further covers an end surface of the insulating elastomer.

4. The connection apparatus according to claim 2 or 3, wherein the outer conductor covers an outer surface of the insulating elastomer.

5. The connection apparatus according to claim 4, wherein the outer conductor further covers the end surface of the insulating elastomer.

6. The connection apparatus according to claim 2 or 3, wherein the inner conductor further covers an outer surface of the insulating elastomer; and
the outer conductor is provided with a through hole, wherein the inner conductor, the insulating elastomer, and a fastening post are disposed in the through hole.

7. The connection apparatus according to any one of claims 1 to 6, wherein the fastening structure is the fastening post; and
there is an insertion structure between the fastening post and the conductor assembly.

8. The connection apparatus according to any one of claims 1 to 5, wherein the fastening structure is provided with a through hole, and the conductor assembly is disposed in the through hole.

9. The connection apparatus according to claim 1, wherein one end of the insulating elastomer is in an arc shape;
the inner conductor covers an outer surface of the arc-shaped end of the insulating elastomer; and
the outer conductor is provided with a through hole, wherein the inner conductor, the insulating elastomer, and a fastening post are disposed in the through hole.

10. The connection apparatus according to claim 9, wherein another end of the insulating elastomer is provided with a hole;
the fastening structure is a columnar step-shaped structure; and
an insertion structure is formed between the fastening structure and the insulating elastomer through the hole and the columnar step-shaped structure.

11. The connection apparatus according to any one of claims 1 to 10, wherein the insulating elastomer comprises:
silicone rubber, nitrile butadiene rubber, or fluorosilicone rubber.

12. The connection apparatus according to any one of claims 1 to 11, wherein the inner conductor or the outer conductor comprises:
silver paste, tin, silver, copper, nickel, or alloy.

13. A radio frequency module, comprising at least one device and at least one connection apparatus according to any one of claims 1 to 13;
the device is provided with an interface, wherein the interface comprises an inner conductor connection interface, an outer conductor connection interface, and an insulation area, and the insulation area insulates the inner conductor connection interface and the outer conductor connection interface; and
one end of an inner conductor of the connection apparatus is connected to the inner conductor connection interface, and one end of an outer conductor of the connection apparatus is connected to the outer conductor connection interface.

14. The radio frequency module according to claim 13, wherein the device comprises a circuit board or a filter.
